# EUROPEAN PATENT APPLICATION

(11) **EP 4 586 428 A1**
(43) Date of publication of application: **16.07.2025**
(21) Application number: 25150546.7
(22) Date of filing: 07.01.2025
(51) Int. Cl.: H02H 3/087, H02H 7/26, H03K 17/08, H01H 9/54, H02H 3/02, H02H 9/00

(54) **SOLID-STATE CIRCUIT BREAKER**

(30) Priority: 11.01.2024 CN 202420073976 U
(71) Applicant: Schneider Electric (China) Co., Ltd., Beijing 100102 (CN)
(72) Inventor: BAI, Heng, Shanghai, 201203 (CN); FAN, Jianguo, Shanghai, 201203 (CN); SHI, Ying, Shanghai, 201203 (CN); ZHAO, Haijun, Shanghai, 201203 (CN); LU, Feng, Shanghai, 201203 (CN); CHEN, Jiamin, Shanghai, 201203 (CN)
(74) Representative: Manitz Finsterwald Patent- und Rechtsanwaltspartnerschaft mbB

(57) **Abstract**

The present disclosure relates to a solid-state circuit breaker, including a first switch (S1), a second switch (Q1), a first capacitor (C1), and a first diode (D1), wherein, a first terminal of the first switch (S1) is connected to a positive electrode (P1) of an input terminal, a second terminal of the first switch (S1) is connected to a first terminal of the second switch (Q1), a second terminal of the second switch is connected to a positive electrode of an output terminal (P2), a first terminal of the first capacitor (C1) is connected to the first terminal of the second switch (Q1), a second terminal of the first capacitor (C1) is connected to a negative electrode of the input terminal (N2), a cathode of the first diode (D1) is connected to the second terminal of the second switch (Q1), and an anode of the first diode is connected to a negative electrode of the output terminal (N2).

## Description

### TECHNICAL FIELD

The present disclosure relates to an apparatus for bidirectional direct-current solid-state short-circuit protection, and more particularly to a solid-state circuit breaker for bidirectional short-circuit protection which is suitable for a direct-current system.

### BACKGROUND

With the development of power electronics technology, the solid-state circuit breakers are widely used in power systems. However, short-circuit faults in the direct-current system pose a serious threat to equipment and personnel safety, and have a significant impact on the stable operation of the power system, so it is required that the branch protection switch of the distribution system can respond and cut off the faulty branch at microseconds (us) time scale. However, for traditional solid-state circuit breakers, the upstream current at the moment of short-circuit is relatively large, making it difficult to achieve selectivity. Moreover, for traditional solid-state circuit breakers, after the switching devices of the main circuit are disconnected, the energy of the inductor of the line does not have a free-wheeling circuit, and the superposition of induced voltage and input voltage often causes overstress in the switching devices of the main circuit. Therefore, the existing technology still needs to be improved and enhanced.

### SUMMARY

In view of the above-mentioned shortcomings of the prior art, the present disclosure relates to an apparatus for bidirectional direct-current solid-state short-circuit protection to be capable of providing a solid-state circuit breaker for bidirectional short-circuit protection used for the direct-current system with fast response speed and high reliability, so as to protect the circuit from overload and short-circuit faults and ensure the safe operation of the circuit.

According to an embodiment of the present application, a solid-state circuit breaker is provided, including a first switch, a second switch, a first capacitor, and a first diode, wherein a first terminal of the first switch is connected to a positive electrode of an input terminal, a second terminal of the first switch is connected to a first terminal of the second switch, a second terminal of the second switch is connected to a positive electrode of an output terminal, a first terminal of the first capacitor is connected to a first terminal of the second switch, a second terminal of the first capacitor is connected to a negative electrode the input terminal, a cathode of the first diode is connected to a second terminal of the second switch, and an anode of the first diode is connected to a negative output terminal.

According to an embodiment of the present application, the solid-state circuit breaker further comprises a transient voltage suppressor (TVS) and a second diode, wherein the transient voltage suppressor is connected in parallel with the first capacitor, the second diode is connected in parallel with the second switch and a cathode of the second diode is connected to a first terminal of the second switch and an anode of the second diode is connected to a second terminal of the second switch.

According to an embodiment of the present application, the solid-state circuit breaker further includes a first overcurrent protection apparatus and a second overcurrent protection apparatus, wherein the first overcurrent protection apparatus is connected in series with the first capacitor and the second overcurrent protection apparatus is connected in series with the first diode.

According to an embodiment of the present application, the solid-state circuit breaker further includes a first inductor and a second inductor, wherein the first inductor is connected in series between the positive electrode of the input terminal and a node where the first terminal of the second switch and the first terminal of the first capacitor are connected, and the second inductor is connected in series between a node where the second terminal of the second switch and a first terminal of the first inductor are connected and the positive electrode of the output terminal.

According to an embodiment of the present application, a solid-state circuit breaker is provided, which uses power electronic devices as solid-state circuit breaker devices. It quickly disconnects the main circuit within microseconds when an overload or short-circuit occurs in the main circuit. At the moment of the short-circuit, an internal capacitor of the circuit breaker discharges to the short-circuit load to provide short-circuit energy, thereby ensuring that the change range of the current in the upstream main circuit is small or basically remains unchanged at the moment of the short-circuit of the output, which is beneficial to selective protection. Moreover, the circuit breaker has a built-in free-wheeling circuit. After the main switch device is disconnected, the circuit is disconnected, and the energy of the inductor of the line can be absorbed through the load or through the internal capacitor of the circuit breaker, which is beneficial to reducing the stress of the main switch device, extending the life of the device, and reducing losses. In addition, the combined use of the main switch device with an intelligent mechanical switch is beneficial to saving costs. And such a design of the circuit breaker can achieve bidirectional short-circuit protection suitable for the direct-current systems.

### BRIEF DESCRIPTION OF DRAWINGS

The aspects, features, and advantages of the present disclosure will become more apparent and easily understood from the following description of the embodiments in conjunction with the accompanying drawings, where:
Fig. 1 shows a schematic diagram of the circuit structure of a solid-state circuit breaker according to the present application;
Fig. 2 shows a schematic diagram of the circuit structure of the protection logic for the short-circuit of the output side of the solid-state circuit breaker according to the present application; and
Fig. 3 shows a schematic diagram of the circuit structure of the protection logic for the short-circuit of the input side of the solid-state circuit breaker according to the present application.

### DETAILED DESCRIPTION

The application will be described in detail below with reference to exemplary embodiments thereof. However, the present application is not limited to the embodiments described herein, rather it may be implemented in many different forms. The embodiments described are provided only so that this disclosure will be thorough and complete, and will fully convey the concept of the application to those skilled in the art. Features of the various embodiments described may be combined with or substituted for each other unless expressly excluded or should be excluded from the context.

In the embodiments of the present application, unless otherwise expressly stated, "connect" and "contact" do not mean "directly connect" or "directly contact", but only need to be electrically connected. In addition, "first", "second", etc. or similar expressions herein are only used for descriptive and distinguishing purposes and do not represent any priority or order, and they cannot be understood as indicating or implying the relative importance of the corresponding members, nor do they represent whether the described parameter values are the same or different.

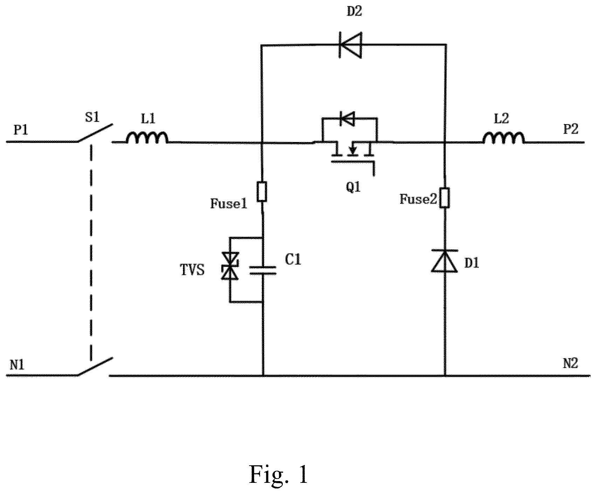

Fig. 1 shows a schematic diagram of the circuit structure of a solid-state circuit breaker according to the present application.

As shown in Fig. 1, the solid-state circuit breaker includes an intelligent mechanical switch S1, a main switching device Q1, a power inductor L1, a power inductor L2, a transient voltage suppressor TVS, a capacitor C1, a diode D1, a diode D2, a fuse Fusel, a fuse Fuse2, and in which, P1 and N1 are the direct-current input terminals, which are the positive electrode of the input and the negative electrode of the input, respectively, and P2 and N2 are the direct-current output terminals, which are the positive electrode of the output and negative electrode of the output, respectively. The output terminals P2 and N2 can be connected to loads (such as EMC circuits, X capacitors, Y capacitors, etc.).

According to the embodiment of the present application, as shown in the figure, the intelligent mechanical switch S1 is connected in series to the positive electrode of the input side, which can realize to be opened and closed manually or can be opened and closed automatically by disconnecting a contact of a main circuit through electrical control commands, the intelligent mechanical switch S1 is a power device with a certain overcurrent capability. The power inductor L1 and the power inductor L2 are connected in series with the positive electrode of the input side and the positive electrode of the output side, respectively, to limit the rise of the current (such as the instantaneous current in the main circuit). The main switching device Q1 is connected in series after the positive electrode of the input and the power inductor L1 as a circuit breaker protection device. The main switching device Q1 shown in Fig. 1 is implemented using such as a metal oxide semiconductor field effect transistor (MOSFET) with an additional anti-parallel diode. This is because a parasitic anti-parallel diode of the MOSFET has weak overcurrent capability, under the short-circuit condition of the input and the surge voltage condition of the output, the additional anti-parallel diode is required to ensure that the instantaneous current can be reversely charged to the capacitor C1 or the transient voltage suppressor TVS. Otherwise, an instantaneous large current will burn out the parasitic anti-parallel diode of the MOSFET. Optionally, the main switching device Q1 may also be a power electronic switching device such as an insulated-gate bipolar transistor (IGBT). The capacitor C1 is connected in series between the positive and negative electrodes. Specifically, connected in series between the drain electrode of the main switching device Q1 and the negative electrode of the input. According to the embodiment of the present application, at the moment of the short-circuit of the output side (i.e., the short-circuit between P2 and N2), the capacitor C1 rapidly discharges to provide short-circuit current, which is beneficial to achieving selective protection. At the same time, after the main switching device Q1 reaches the tripping threshold and is turned off, the energy of the upper-level line (i.e., the energy of the input side) can freewheel to capacitor C1. The diode D1 is connected in series between the positive and negative electrodes of the output terminal. Specifically, the cathode of the diode D1 is connected to the source electrode of the main switching device Q1, and the anode of the diode D1 is connected to the N line. According to the embodiment of the present application, when the output side is short-circuited (i.e., short-circuited between P2 and N2) and the main switching device Q1 reaches the tripping threshold and is turned off, the diode D1 provides a free-wheeling circuit for an inductive energy of the lower-level line (i.e., the energy of the output side). That is, the inductive energy of the lower-level line can freewheel to the load through diode D1. And optionally, the diode D1 can also be replaced by a silicon controlled rectifier (SCR) and it can realize protection for a reverse connection of the positive and negative of the output and protection for a short-circuit fault to the ground under specific conditions. The transient voltage suppressor TVS is connected in parallel at both terminals of the capacitor C1 and is used to protect the main switching device Q1 and other power electronic devices from damage by excessive voltage. When an overvoltage or peak voltage occurs in the circuit, the transient voltage suppressor TVS can respond quickly and clamp the voltage at a safe level, thereby protecting the related electronic devices from damage. According to the embodiment of the present application, the transient voltage suppressor TVS can prevent the voltage of the capacitor C1 from being too high during a surge of the input side, the transient voltage suppressor TVS can also protect the main switching device Q1, such as preventing the main switching device Q1 from being subjected to voltages exceeding its maximum operating voltage. In order to achieve more effective protection, the selection of the type the transient voltage suppressor TVS can be selected according to the maximum operating voltage, current, etc. of the power electronic device to be protected. According to the embodiment of the present application, an overcurrent protection apparatus (such as the fuse Fuse1 and the fuse Fuse2) is disposed, wherein the fuse Fuse1 is connected in series with capacitor C1, which can be used to prevent continuous short-circuit of the input caused by failure of TVS or C1, and the fuse Fuse2 is connected in series with the diode D1 to prevent overcurrent of the current caused by the reverse connection of the positive and negative of the output.

Optionally, the diode D2 is connected in parallel with the main switching device Q1 to prevent insufficient overcurrent capability of the main switching device Q1, especially the instantaneous overcurrent capability under the surge conditions.

As the circuit of the solid-state circuit breaker shown in Fig. 1, when the circuit is operating normally, power is supplied normally between the P1 and N1 of the input side, the switches S1 and Q1 are closed in sequence, and the load operates normally.

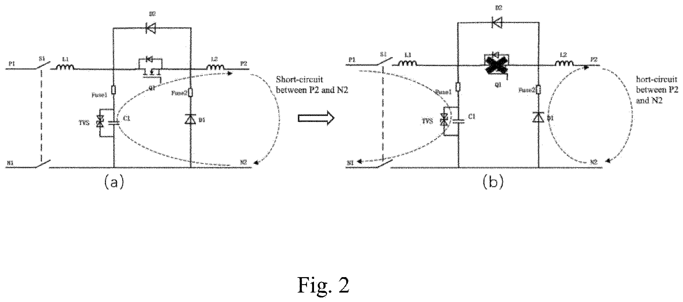

Fig. 2 shows a schematic diagram of the circuit structure of the protection logic for the short-circuit of the output side of the solid-state circuit breaker according to the present application. The schematic diagram of the circuit (a) in Fig. 2 shows a situation where a short-circuit occurs between the P2 and N2 of the output side and the main switching device Q1 has not been disconnected at the moment of the short-circuit. The schematic diagram of the circuit (b) in Fig. 2 shows a situation where a short-circuit occurs between the P2 and N2 of the output side and the main switching device Q1 is disconnected upon the moment of the short-circuit.

According to the embodiment of the present application, when a short-circuit occurs between the P2 and N2 of the output side and the main switching device Q1 has not been disconnected at the moment of the short-circuit, at this time, the intelligent mechanical switch S1 is in a closed state, the voltage of the output side decreases instantaneously, the capacitor C1 discharges to the output side through the path of the Fuse1, the main switching device Q1, and the inductor L2 as shown by the dotted arrow shown in the schematic diagram of the circuit (a) in Fig. 2, the output current increases sharply, at this time, the current flowing through the main switching device Q1 also increases sharply, the voltage of the two terminals of the main switching device Q1 becomes small after the capacitor C1 is discharged, while the current on the input side remains basically unchanged, that is when the output side is short-circuited, the upstream (input side) current will not be increased due to the short-circuit of the downstream (the short-circuit of the output side) causing upstream protection apparatus tripping. According to the embodiment of the present application, it is ensured that the change range of current in the upstream main circuit is small or basically remains unchanged at the moment of the short-circuit of the output, thereby realizing that only the faulty part is disconnected without affecting the operation of other normal parts, reducing the fault range, and facilitating selective protection.

According to an embodiment of the present application, with continuing reference to the schematic diagram of the circuit (a) in Fig. 2, a test point is provided at the main switching device Q1, when an output current is detected to increase to reach the tripping threshold of the main switching device Q1, as shown in the schematic diagram of the circuit (b) in Fig. 2, the main switching device Q1 is turned off ("X" in Fig. 2 indicates that the main switching device Q1 is turned off at this time), but the intelligent mechanical switch S1 remains closed at this time, and the energy of the downstream inductor and line forms a freewheeling circuit though the diode D1, Fuse2, the inductor L2, and the load (not shown) as shown by the dotted arrow shown in the schematic diagram of the circuit (b) in Fig. 2; the energy of the upstream inductor and line forms a freewheeling circuit though inductor L1, Fuse1, and capacitor C1, as shown by the dotted arrow shown in the schematic diagram of the circuit (b) in Fig. 2. According to the embodiment of the present application, at the moment of short-circuit on the output side, after the main switching device Q1 is turned off, through such two free-wheeling circuits, the problem of overstress of the main circuit switching device caused by the superposition of the induced voltage and the input voltage can be avoided, thereby extending the life of the device and reducing losses.

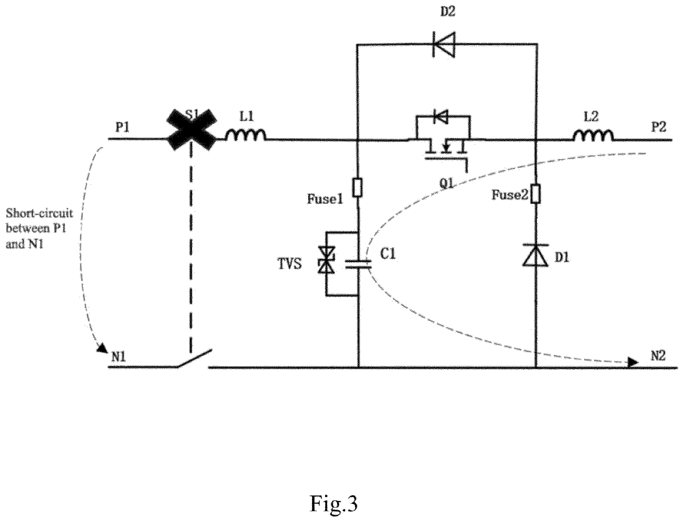

Fig. 3 shows a schematic diagram of the circuit structure of the protection logic for the short-circuit of the input side of the solid-state circuit breaker according to the present application.

According to the embodiment of the present application, when a short-circuit occurs between the P1 and N1 of the input side, the energy of the output side (i.e., the load) will instantly be back-fed to the short-circuit points of the input side. However, since the main switching device Q1 is a one-way switch, providing a switch device Q2 in parallel with the main switch device Q1 to achieve bidirectional switching would increase costs. Moreover, the load energy is usually relatively small, so a speed of turn-off at the microsecond level is usually not required. However, the method of setting an intelligent mechanical switch S1 controlled by an electrical control command to work in conjunction with the main switch device Q 1 is possible to achieve a bidirectional (input-side and output-side) short-circuit protection of the circuit while reducing costs, thereby enhancing reliability and stability.

According to an embodiment of the present application, optionally, a detection point is provided at the intelligent mechanical switch S1. When a short-circuit occurs between the P1 and N1 of the input side, the intelligent mechanical switch S1 is controlled to be disconnected through an electrical control command ("X" in Fig. 3 indicates that the intelligent mechanical switch S1 is disconnected at this time). After the intelligent mechanical switch S1 is disconnected, the residual energy of the output side freewheels through the circuit formed by the inductor L2, the main switching device Q1, and the capacitor C1, as shown by the dotted arrow shown in Fig. 3, optionally, or freewheels through the circuit formed by the inductor L2, the main switching device Q1, the main switching device Q1 or the diode D2, and the capacitor C1, thereby reducing the impact on the output side.

It should be noted that, for the sake of clarity and conciseness, only parts relevant to the embodiments of the present application are shown in the drawings, but those skilled in the art will understand that the equipment or devices shown in the drawings may include other necessary units.

The block diagrams of circuits, devices, apparatus, equipment, and systems involved in the present application are only illustrative examples and are not intended to require or imply that they must be connected, disposed, or configured in the manner shown in the block diagrams. As those skilled in the art will recognize, these circuits, devices, apparatus, equipment, and systems may be connected, disposed, and configured in any manner that achieves the desired purpose. The quantities referred to in the present application are merely illustrative.

Those skilled in the art can clearly understand that for the convenience and simplicity of description, the specific working processes of the systems, apparatus, and units described above can refer to the corresponding processes in the embodiments for the method stated above, and will not be described again here.

Those skilled in the art should understand that the above-mentioned specific embodiments are only examples and not limitations. Various modifications, combinations, partial combinations, and substitutions can be made to the embodiments of the present disclosure according to design requirements and other factors, as long as they are within the scope of the appended claims or their equivalents, that is, they belong to the scope of rights to be protected by this disclosure.

## Claims

1. A solid-state circuit breaker, comprising a first switch, a second switch, a first capacitor, and a first diode,
wherein, a first terminal of the first switch is connected to a positive electrode of an input terminal, a second terminal of the first switch is connected to a first terminal of the second switch, a second terminal of the second switch is connected to a positive electrode of an output terminal, a first terminal of the first capacitor is connected to the first terminal of the second switch, a second terminal of the first capacitor is connected to a negative electrode of the input terminal, a cathode of the first diode is connected to the second terminal of the second switch, and an anode of the first diode is connected to a negative electrode of the output terminal.

2. The solid-state circuit breaker of claim 1, further comprising a transient voltage suppressor and a second diode,
wherein the transient voltage suppressor is connected in parallel with the first capacitor, the second diode is connected in parallel with the second switch, and a cathode of the second diode is connected to the first terminal of the second switch and an anode of the second diode is connected to the second terminal of the second switch.

3. The solid-state circuit breaker of claim 2, further comprising a first overcurrent protection apparatus and a second overcurrent protection apparatus,
wherein the first overcurrent protection apparatus is connected in series with the first capacitor, and the second overcurrent protection apparatus is connected in series with the first diode.

4. The solid-state circuit breaker of claim 3, further comprising a first inductor and a second inductor,
wherein, the first inductor is connected in series between the positive electrode of the input terminal and a node where the first terminal of the second switch and the first terminal of the first capacitor are connected, and the second inductor is connected in series between a node where the second terminal of the second switch and a first terminal of the first inductor are connected and the positive electrode of the output terminal.

5. The solid-state circuit breaker of claim 1, wherein:
the first switch is an intelligent mechanical switch configured to disconnect a contact of a main circuit though an electrical control command and having a current breaking capability,
the second switch is a metal oxide semiconductor field effect transistor (MOSFET) with an anti-parallel diode or an insulated-gate bipolar transistor (IGBT).

6. The solid-state circuit breaker of claim 1, wherein:
the first diode can also be replaced by a silicon controlled rectifier.

7. The solid-state circuit breaker of claim 3, wherein:
the first overcurrent protection apparatus and the second overcurrent protection apparatus are fuses.
